# EUROPEAN PATENT SPECIFICATION

(11) **EP 1 504 141 B1**
(45) Date of publication and mention of the grant of the patent: **22.07.2009**
(21) Application number: 03720838.6
(22) Date of filing: 15.05.2003
(51) Int. Cl.: C30B 7/00, C30B 29/60, C01B 19/04, H01L 33/00

(54) **METHOD FOR PRODUCING INORGANIC SEMICONDUCTOR NANOCRYSTALLINE RODS AND THEIR USE**
VERFAHREN ZUR HERSTELLUNG VON INORGANISCHEN HALBLEITENDEN NANOKRISTALLINEN STENGELN UND IHRE ANWENDUNGEN
PROCEDE DE PRODUCTION DE TIGES NANOCRISTALLINES SEMI-CONDUCTRICES INORGANIQUES ET LEUR UTILISATION

(30) Priority: 15.05.2002 US 144777; 24.09.2002 US 412806 P
(43) Date of publication of application: 09.02.2005
(73) Proprietor: YISSUM RESEARCH DEVELOPMENT COMPANY OF THE HEBREW UNIVERSITY OF JERUSALEM, 91390 Jerusalem (IL)
(72) Inventor: BANIN, Uri, 90805 Mevasseret Zion (IL); KAN, Shi, Hai, 96704 Jerusalem (IL)
(74) Representative: Grünecker, Kinkeldey, Stockmair & Schwanhäusser Anwaltssozietät
(86) International application number: PCT/IL2003/000391
(87) International publication number: WO 2003/097904

(56) References cited:
- WO-A-01/07689
- WO-A-02/29140
- WO-A1-98/39251
- US-A- 5 505 928
- US-A1- 2002 011 564
- US-B1- 6 179 912
- US-B1- 6 225 198
- US-B1- 6 306 736
- TRENTLER ET AL.: "Solution-liquid-solid growth of indium phosphide fibers from organometallic precursors: elucidation of molecular and nonmolecular components of the pathway" J.AMCHEM.SOC, vol. 119, pages 2172-2181, XP001166840 cited in the application
- LI ET AL: "Regular Arrays of GaN nanorods" J.CRYSTAL GROWTH, vol. 236, March 2002 (2002-03), pages 71-76, XP004339650

## Description

### FIELD OF THE INVENTION

This invention relates to a method for synthesizing rod-shaped semiconductor nanocrystals, *inter alia* rod shaped Group III-V semiconductor nanocrystals.

### LIST OF REFERENCES

The following references are considered to be pertinent for the purpose of understanding the background of the present invention:
1. R. L. Wells et al., Chem. Mater. 1, 4 (1989).
2. A. P. Alivisatos and M. A. Olshavsky, U.S.Pat. No. 5,505,928.
3. A. A. Guzelian, U. Banin, A. V. Kadavanich, X. Peng, A. P. Alivisatos, Appl. Phys. Lett. 69, 1432 (1996).
4. R. S. Wagner, in Whisker Technology, A. P. Levitt, Ed. (Wiley-Interscience, New York, 1970), pp.47-119.
5. A. M. Morales, and C. M. Lieber, Science 279, 208 (1998).
6. X. F. Duan, and C. M. Lieber, Adv. Mater. 12, 298 (2000).
7. Y. Cui, X. F. Duan, J. T. Hu, C. M. Lieber, J. Phys. Chem. B 104, 5213 (2000).
8. M. S. Gudiksen, L. J. Lauhon, J. F. Wang, D. C. Smith, C. M. Lieber, Nature 415, 617 (2002).
9. Gudiksen, J. F. Wang, C. M. Lieber, J Phys. Chem. B 105, 4062 (2001).
11. Y Huang, X. F. Duan, Y Cui, L. J. Lauhon, K. H. Jim, C. M. Lieber, Science 294, 1313 (2001).
12. J. D. Holmes, K. P. Johnston, R. C. Doty, B. A. Korgel, Science 287, 1471 (2000).
13. J. T. Hu, L. S. Li, W. D. Yang, L. Manna, L. W. Wang, A. P. Alivisatos, Science 292, 2060 (2001).
14. M. Kazes, D. Lewis, Y Ebenstein, T. Mokari, U. Banin, Adv. Mater. 14, 317 (2002).
15. Y Huang, X. F. Duan, Q. Q. Wei, C. M. Lieber, Science 291, 630 (2001).
16. X. G Peng, L. Manna, W D. Yang, J. Wickham, E. Scher, A. Kadavanich, A. P. Alivisatos, Nature 404, 59 (2000)*.*
17. A. P. Alivisatos et al., U.S. Pat. 6,225,198.
18. A. P. Alivisatos et al., U.S . Pat, 6,306,736.
19. U. Banin and Y W Cao, PCT Application WO 00/11668.
20. Y W. Cao, and U. Banin, J. Am. Chem. Soc. 122, 9692 (2000).
21. T. J. Trentler, S. C. Geol, K. M. Hickman, A. M. Viano, M. Y Chiang, A. M. Beatty, P. C. Gibbons, W E. Buhro, J. Am. Chem. Soc. 119, 2172 (1997).
22. M. Brust et al., J. Chem. Soc. Chem. Commun. 801 (1994).
23. C. L. Cleveland, W. D. Luedtke, U. Landman, Phys. Rev. Lett. 81, 2036 (1998); ibid Phys. Rev. B 60, 5065 (1999).
24. W. W. Hutchison, S. M. Reed, M. G Marvin and J. E. Hutchison, J. Am. Chem. Soc., 122, 12890 (2000).
25. Heng Yu, Patrick C.Gibbons, K.F.Kelton, and William E.Buhro, J.Am.Chem.Soc., 123, 9198-9199 (2001).
26. Li et al. "Regular arrays of GaN nanorods", J. Crystal Growth ,236 pp. 71-76, March 2002.

### BACKGROUND OF THE INVENTION

Miniaturization of electronic and optical devices requires semiconductors of nanometer size domain. Inorganic semiconductors, in particular Group III-V semiconductors, exhibit features that make them attractive for use in solid state electronics as well as optical devices (e.g., high thermal stability, high electron mobility, low energy band gap, and direct-band gap behavior.

Developing preparation methods of semiconductor nanocrystals has been an important branch of synthetic chemistry. For many of the semiconductors, syntheses through the reaction of simple reactants have been proved to be impossible, thus only until recent years, some of them can be prepared through the use of organometallic precursors in organic solvents. The typical examples are Group III-V semiconductor nanocrystals, which are formed by dissolving a Group IIIa precursor and a Group Va precursor in a solvent and then applying heat to the obtained mixture of solvent and precursors. More specifically, Group III-V semiconductor nanocrystals may be produced by using silyl cleavage. Specifically, Group III halides have been reacted with E(SiMe₃)₃, where E=P,As, in hydrocarbon solvents to yield nanocrystalline III-V semiconductors [**1**].

One of the most important challenges in current nanocrystal technology is that of achieving shape and size control of growing nanocrystal structures. Alivisatos et al. [**2**] described a process for forming Group III-V semiconductor nanocrystals wherein size control is achieved through the use of a crystallite growth terminator such as nitrogen- or phosphorus-containing polar organic solvent, for example pyridine, quinoline or mono-, di-, and tri-(C₁₋₆ alkyl)phosphines.

High quality group III-V semiconductor nanocrystals were produced by a method consisting of injecting the precursors into a hot coordinating solvent such as trioctyl-phosphine (TOP) [**3**].

All the above-mentioned processes can yield only spherically shaped nanocrystal semiconductors (also termed quantum dots) of the group III-V.

In the nanometer size domain the properties of semiconductors depend on size and shape. The growth of crystalline wire-like structures based on the vapor-liquid-solid (VLS) mechanism has been developed [**4**]. In the VLS method, a liquid metal cluster acts as a catalyst where the gas-phase reactants adsorb, subsequently leading to whisker growth from the supersaturated drop. Laser ablation was combined to form nanometer-sized metal clusters as catalysts with the VLS mechanism, to grow a variety of semiconductor nanowires, doped nanowires, and nanowire superlattices with lengths in the micrometer range [**5-8**]. The diameters of the nanowires could be tuned by changing the size of the catalyst clusters [**9**] and for silicon nanowires, the smallest diameter reported was 6 nm. For InAs and other III-V semiconductor nanowires, the average diameters are larger than 10 nm. Such diameters are at the onset of the strong quantum confinement regime providing rather limited band gap tunability by size effects. A whole set of optoelectronic devices including transistors, detectors and a light emitting diode were demonstrated using these nanowire building blocks [**10, 11**]. Micron long silicon nanowires with diameters of 4-5 nm were also prepared in a pressurized solution system by using gold nanocrystals as catalyst [**12**].

Rod-shaped nanocrystals are interesting because the rod shape produces polarized light emission leading to polarized lasing [**13, 14**]. Additionally, rod-shaped particles are suitable for integration into nano-electrode structures for the production of electronic devices such as sensors, transistors, detectors, and light-emitting diodes [**11, 15**]. A recent example of rod-shaped nanocrystals was described in relation with CdSe nanocrystals [**16, 17**]. Shape control in this case was realized by kinetically controlled growth along the special c-axis of wurtzite CdSe nanocrystals through the use of a mixture of surfactants. Such a process is not easily applicable for the growth of cubic-structured semiconductor nanorods, e.g. nanorods of a few important III-V semiconductors. Therefore a novel and completely different rod growth mechanism is needed for these compounds.

a binary surfactant mixture capable of promoting the growth of either spherical semiconductor nanocrystals or rod-like semiconductor nanocrystals.

Further, from [0026] GaN semiconductor nanorods are known, which are terminated with a non-semiconducting metal catalyst nanoparticle (Au).

Finally, from WO 98/39251 semiconducting carbide (SiC) nanorods having a transition metal catalyst at one end are known.

### SUMMARY OF THE INVENTION

There is a need in the art to facilitate preparation of nanocrystalline semiconductors, especially Group III-V semiconductors, having rod-like shape of controlled dimensions in a controllable and repeatable manner, which are not available to date. The term "*III-V semiconductor*" is used to describe crystalline material or solid solution formed from the reaction of at least one metal precursor from group IIIa of the Periodic Table of the Elements (B, Al, Ga, In, and T1) and at least one element from group Va of the Periodic Table of the Elements (N, P, As, Sb, and Bi). It should be noted that the expression "*at least one*" is used here in recognition of the fact that, for example, a particular Group IIIa metal precursor may be reacted with more than one particular Group Va precursor, e.g., GaAsP, and vice versa, e.g. InGaAs.

The term "*nanocrystal having rod-like shape*" or "*nanorod*" is meant a nanocrystal with extended growth along the first axis of the crystal while maintaining the very small dimensions of the other two axes, resulting in the growth of a rod-like shaped semiconductor nanocrystal of very small diameter, where the dimensions along the first axis may range from about 10 nm to about 500 nm. The nanorods prepared by the method of the invention may have one end made of non semiconducting material.

Examples of Group III-V semiconductors that may be prepared by the method of the invention are InAs, GaAs, GaP, GaSb, InP, InSb, AlAs, AlP, AlSb and alloys such as InGaAs, GaAsP, InAsP. Examples of Group II-VI semiconductors that may be prepared by the method of the invention are CdS, CdSe, CdTe, ZnS, ZnSe, ZnTe, HgS, HgSe, HgTe and the like. Examples of Group I-VII semiconductors are CuCl, CuBr, CuI, AgCl, AgBr, AgI and the like.

The main idea of the present invention is based on introducing nanoparticles of a metal catalyst that serve as starting nanocrystals from which nanorods of inorganic semiconductors grow in solution while stopping the growth to obtain rods. Without being bound to theory, it is proposed that the reaction precursors dissolve in the metal nanoparticles and the semiconductor nanorods grow from these particles.

The metal catalyst can be made, for example, of a transition metal, e.g. Zn, Cd, Mn, etc., a Group IIIa metal , e.g. In, Ga, Al, alloys of such metals such as for example Au-In, or core/shell layered metal particle. More specific examples of transition metal catalysts are: Group III metals such as Fe, Co, Ni, etc., Pd and Pt; Group Ib metals, for example Au and Ag, or alloys of these metals such as for example Au-In, or core/shell layered metal particles. It should be noted that in the case of using catalysts made of magnetic metals such as Fe, Co and Ni, the produced nanorods may also possess magnetic properties. The catalyst nanoparticles may either be formed *in-situ* in the reaction process from one of the precursor materials by using a reducing agent or be added to the reaction process.

Thus, the present invention provides a method for the production of inorganic semiconductor nanocrystals having a rod-like shape as defined in claim 1. Preferred embodiments of the inventive method are subject to the dependent claims.

According to a preferred embodiment, the reaction product obtained in step (i) above is cooled before the purification step. The purification is carried out by centrifugation that affords purified nanorods having selected size .

The rod-shaped nanocrystals prepared by the method of the invention possess diameters that depend on the diameter of the catalyst nanoparticles used in their growth. The diameter of the nanoparticles used in the method of the invention are typically in the range of between about 1 to about 50 nm. Further parameters that may affect the size and shape of the reaction products are, *inter alia,* the following: the type of the metal catalyst, the reaction temperature, duration of the reaction and concentration of precursors.

The rods exhibit both length and shape dependent optical properties. With increasing length, the band gap shifts to the red, and unlike spherical quantum dots, the photoluminescence is linearly polarized in accordance with the rod shape.

The rod-shaped nanocrystals obtained by the method of the invention usually have organic ligands as a coating on their outer surfaces. Such organic ligands affect the solubility of the particles and may be substituted or removed, according to the application intended for said particles after the reaction is completed.

The reaction precursors used in the method of the invention are selected from Group Ib, IIb or IIIa metal compounds, Group VIIa, VIa or Va non-metal compounds, Group IV element_compounds, compounds comprising both Group Ib and Group VIIa elements, compounds comprising both Group IIb and Group VIa elements and compounds comprising both Group IIIa and Group Va elements. Consequently, the inorganic semiconductor rods prepared by the method of the invention are selected from Group III-V, Group III-V alloys, Group II-VI, Group I-VII, and Group IV semiconductors.

Examples for single-source precursor compounds, e.g. for Group III-V semiconductors: {*t*-Bu₂In[µ-P(SiMe₃)₂]}₂, [*t*-BuZIn(*µ*-PH₂)]₃; for Group IV semiconductors: (C₆H₅)₂SiH₂).

The metal catalyst is added directly into the reaction mixture, together with the precursor solution. Alternatively, the metal catalyst may be produced *in situ* by using an agent capable of producing it, for example by using a reducing agent capable of reducing the Group IIIa metal precursor into the corresponding Group IIIa metal. According to another preferred embodiment, the present invention provides a method for the production of InAs semiconductor nanocrystals having rod-like shape, comprising introducing a precursor solution of an In source and an As source into a high-boiling point organic solvent comprising NaBH₄, said high- boiling point organic solvent having a temperature above 200 °C, more preferably above 300°C, thereby forming upon cooling and optionally annealing a reaction product comprising InAs nanocrystals of various shape and size, and subsequently carrying out at least one centrifugal step so as to obtain InAs semiconductor nanocrystals having rod-like shape and selected size.

In the above embodiment the catalyst, namely indium nanoparticles, is produced *in situ* by reduction of the indium source compound with NaBH₄. In an alternative procedure the metal catalyst is provided together with the precursor solution, without the need to produce it *in situ* during the formation of the nanorods. material; an optical device comprising a plurality of said nanorods; a photocell comprising semiconductor nanorods, produced by the method of the present invention, serving as an absorbing chromophore; and an optical device comprising a plurality of InAs semiconductor nanocrystal nanorods produced by the method of the present invention.

### BRIEF DESCRIPTION OF THE DRAWINGS

In order to understand the invention and to see how it may be carried out in practice, preferred embodiment will now be described, by way of non-limiting example and with reference to the accompanying drawings, in which:
**Fig. 1** is a schematic illustration of the growth mechanism of InAs nanorods according to the invention;
**Figs. 2A to 2D** illustrate TEM images showing a separation stage of the method of the invention and TEM of indium nanoparticles: Fig. 2A shows sample before separation, Figs. 2B and 2C show the first and second fractions, respectively, from a synthesis without annealing, and Fig. 2D shows - indium nanoparticles;
**Fig. 3** illustrates the powder XRD patterns of indium nanodroplets of Fig. 2D, of the precipitate from the first step of separation, as shown in Fig. 2A, and rods from the second step of separation, as shown in Fig. 2B (the diffraction peak structure for metallic indium and for NaCl being indicated in the bottom of the figure, while the peaks for InAs being shown in the top);
**Fig. 4A** illustrates high magnification TEM images of a single InAs nanorod; **(B)-(D)** illustrate high resolution TEM images of crystalline InAs nanorods.
**Fig. 5** shows photoluminescence spectrum of the InAs nanorods as shown in Fig. 2B; and
**Fig. 6** illustrates In-As binary phase diagram.
**Figs 7A to C** illustrate TEM images of the first to third fractions of InAs nanorods, using gold catalyst. The rods have similar diameters but different lengths.
**Fig. 8A** shows the room temperature absorption and photoluminescence (PL) spectra in toluene solution of (i)-InAs quantum dots, ∼4nm in diameter; (ii)-nano rods 10x4 nm (length*diameter) (iii) nanorods, 15x4 nm, (iv) nanorods, 22x4 nm. The PL intensity was normalized for clarity of presentation.
**Fig. 8B** illustrates a graph showing the correlation between the shift of the bandgap of InAs quantum rods (taken as the peak of the PL) as a function of rod length. Open circles, experimental results; solid line, model calculation results.
**Fig. 8C** illustrates a graph showing the dependence of the photoluminescence intensity on rod length.
**Fig. 9** illustrates a graph showing the dependence of the polarization dependent photoluminescence in InAs rods (solid lines), versus dots (dashed lines) in stretched polymer films.
**Fig. 10** illustrates TEM images of (A) Au₁₀₁ clusters, (B) InAs nanorods synthesized using Au₁₀₁ clusters.
**Figs. 11A-C** illustrate TEM images of the first to third fractions of InAs nanorods produced with gold cluster catalyst. The rods are seen to have different length but similar diameter. Scale bars, 100 nm.
**Fig. 12** illustrates the size distribution histograms of three fractions of InAs quantum rods from a single synthesis, as shown in Figs. 11A-C First fraction, with mean length 14.2±4.0 nm (histogram **A**), diameter 3.8±0.7 nm (histogram **A'**). Second fraction, with length 10.1±2.1 nm (histogram **B**), diameter 3.9±0.8 nm (histogram **B'**). Third fraction, with length 7.4±1.4 nm (histogram **C**), diameter 3.6±0.7 nm (histogram **C'**).
**Fig. 13** illustrates (**A**) the absorption spectra at room temperature and (**B**) the photoluminescence spectra of the three fractions of InAs quantum rods shown in Figs. 11a-c (excitation wavelength 635 nm).
**Fig. 14** illustrates TEM images of (a)InP nanorods and (b)GaAs nanorods.

### DETAILED DESCRIPTION OF THE INVENTION

The method of the present invention affords the formation of nanorods of inorganic semiconductors with controlled diameters and lengths. The method is exemplified hereinbelow with reference to the preparation of InAs and InP nanocrystal rods, which belong to the important Group IIIa-Va semiconductors. While this is a preferred embodiment, the method of the invention can be used to make any of the inorganic semiconductor nanocrystals in rod shape. Examples for Group III-V semiconductors are GaAs, GaP, GaSb, InP, InSb, AlAs, AlP, AlSb and alloys such as InGaAs, GaAsP, InAsP, etc.; examples for Group II-VI semiconductors are CdS, CdSe, CdTe, ZnS, ZnSe, ZnTe, HgS, HgSe, HgTe, etc.; examples for Group I-VII semiconductors are CuCl, CuBr, CuI, AgCl, AgBr, AgI, etc.; and examples for Group IV semiconductors are Si and Ge.

The method of the invention is usually carried out in a reaction medium free of air and water. The two-source precursor reactants, i.e. the source for the metal part and the source for the nonmetal part of the semiconductors, are combined in a ratio of metal source:nonmetal source ranging from 1:1 to about 3:1. The concentrations of both the two-source- or single-source precursors are in the range of 0.01-0.5 M. The reaction requires an elevated temperature, of at least 200 °C . The solvents used in the method are high boiling point organic solvents, for example phosphines such as trioctylphosphine (TOP), trioctylphosphine oxide (TOPO), triphenylphosphine (TPP), triphenylphosphine-oxide (TPPO), or amines such as hexadecyl amine (HDA) or dodecylamine (DDA) or other strongly coordinating high boiling point solvents. When the reaction is carried out in trioctylphosphine oxide, for example, the reaction is carried out at about 360 °C.

The duration of the reaction depends on the reaction temperature and pressure. For example, the reaction may be completed within periods of from about a few seconds to a few hours. When it is carried out at 300-360 °C and at a pressure higher than normal pressure, for example 100 bar, the reaction duration is shortened.

The reaction is stopped by cooling the reaction mixture (also called growth solution) to room temperature and diluting the growth solution with a hydrocarbon solvent such as toluene. In an optional step, the growth solution is annealed at a temperature up to about 360 °C for a period of between a few minutes to a few hours. Centrifugation is then used to purify the rods and separate them from other reaction products and from the growth medium, resulting in nanorods with a uniform diameters of about 3-4 nm and a length from about 10 nm to about 500 nm.

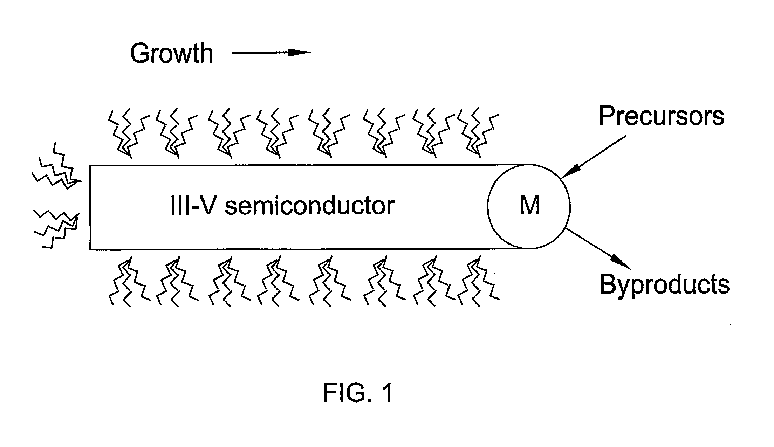

Thus, in a specific example, InAs nanorods were synthesized via the reaction of tris(trimethylsilyl)arsenine ((TMS)₃As) and InCl₃ in trioctylphosphine-oxide (TOPO), using metallic indium or gold as the catalyst. **Fig. 1** shows a schematic illustration of the growth mechanism of III-V semiconductor nanorods. The metallic catalyst, marked M, forms a starting nanocrystal from which the semiconductor nanorod grows, the growing direction shown in the figure signifying that the left end portion of the rod was grown first and then "moved" away from the metallic catalyst during the continuous growth of the nanorod.

At times, a reducing agent, for example NaBH₄, may be added to in-situ create metallic indium nanodroplets that direct the one-dimensional rod growth via a solution-liquid-solid mechanism (hereinafter "SLS mechanism"). The SLS mechanism was first used in the growth of polycrystalline whiskers of III-V semiconductors reported by Buhro and coworkers [**21**]. The so-grown whiskers had diameters in the range of 10-150 nm and lengths of a few micrometers. In our example, the in-situ formed indium nanodroplets are much smaller than the indium droplets used in Buhro's method. These nanodroplets are mostly consumed during the nanorod growth, and the length of the as-prepared nanorods is confined. In addition, we can control the growth effectively by controlling the reaction time. Additionally, several separation stages were introduced to obtain rods of desired length. The reactions are carried out in coordinating solvents leading to soluble rods and the reaction temperature is relatively high resulting in crystalline rods.

The reaction route in the above example can be described as follows:

(a) 2InCl₃ + 6NaBH₄ → 2In + 6NaCl + 3B₂H₆ + 3H₂,

(b) InCl₃ + As(SiMe₃)₃ → InAs + 3Me₃SiCl,

The SLS mechanism requires the addition or the in-situ formation of a metal nanoparticle as a catalyst for rod growth. In the case of in-situ formation, InCl₃ is reduced by NaBH₄ to form metallic indium nanodroplets that direct the one-dimensional rod growth. As these indium nanodroplets are formed, the precursors that are in the immediate vicinity react and allow for immediate growth of the rods effectively competing with further growth of the droplets. In this way, narrow rod diameters may be achieved.

In a typical experiment conducted in an air-free system, 20 mg NaBH₄ and 3 g TOPO were put in a 3-neck flask. A stock solution, containing 0.8 mmol (TMS)₃As and 1.6 mmol InCl₃/trioctylphosphine (TOP) solution (0.3 g/ml), was diluted with 0.5 g TOP. The stock solution was injected at 340 °C into the NaBH₄/TOPO solution under vigorous stirring, followed either by quenching or by annealing at 300°C for a few minutes. The process yields InAs nanorods with a uniform diameter but broad length distribution along with byproducts.

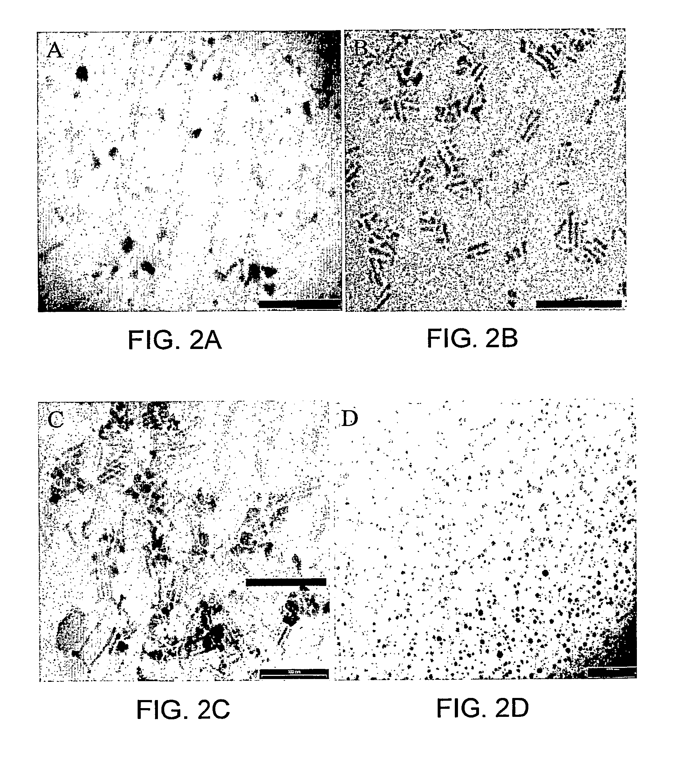

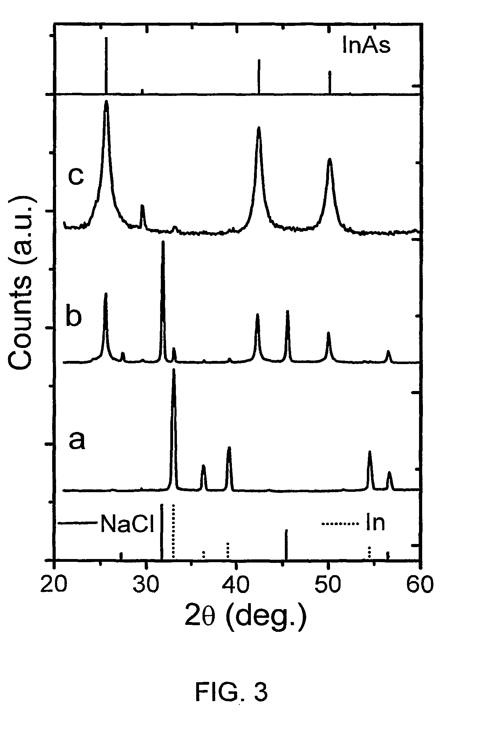

**Fig. 2A** illustrates a TEM image of the reaction products showing a distribution of dots, rods and larger particles. The image was obtained with a Philips CM 120 microscope operated at 100 keV The powder X-ray diffraction pattern of the reaction products is shown as graph **b** in **Fig. 3****.** The pattern was determined using the Philips PW1830/40 X-ray diffractometer operated at 40 kV and 30 mA with Cu K_{α} radiation. As shown, peaks of InAs, metallic indium, and NaCl can be identified. The reaction produces a mixture of InAs dots, InAs rods, big InAs crystals, Indium nanocrystals and NaCl particles. The larger particles dominate the XRD signal and the peaks are therefore rather narrow.

The rods were purified and size-selected by centrifugation. The raw product was diluted with toluene and centrifuged at 6000 rpm (rcf-relative centrifugal force about 4000 g) for 20 min. Under this condition, rods are precipitated together with other big particles while the dots remain soluble. This step was repeated to achieve thorough separation of dots. In the second step, rods were obtained. The precipitate was re-dispersed by ultrasonication in toluene with TOPO added to stabilize the solution. Then, the solution was centrifuged at 4000 rpm (rcf ∼ 1800 g) for 10 min, and the supernatant contained a fraction of nanorods with an average length of about 25 nm and diameter of 3-4 nm. This is illustrated in **Fig. 2B** showing the image obtained with the Philips CM 120 microscope (100 keV). The XRD pattern of the separated rods is shown as graph **c** in **Fig. 3****.** After separation, only InAs peaks and trace amount of indium are detected. The peaks are broadened because of the nanosized diameter of the rods. A fraction of longer nanorods (mean length of about 60 nm) was obtained from the precipitate by repeating the separation step (second separation) using a centrifugal speed of 3000 rpm (rcf about 1000 g) for 10 min. The results are shown in **Fig. 2C****.** The rods are uniform in diameter with broader length distribution. Further separation and re-precipitation steps can be used to improve the uniformity. The corresponding XRD pattern is similar to graph **c** in Fig. 3.

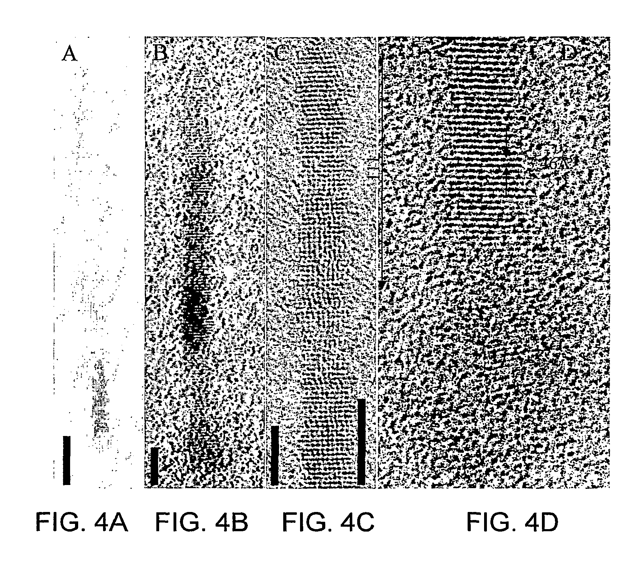

TEM images of individual nanorods are shown in **Fig. 4****.** Here, **A** is the image of a rod observed under high magnification. **B, C** and **D** are high-resolution TEM images of the crystalline nanorods, wherein **B** is the image of a full rod with a diameter of about 3 nm and length of about 50 nm, **C** is the image of a part of a rod with a diameter of about 3.5 nm and length about 50 nm, and **D** is the image of an end part of a rod with a diameter of about 4 nm (scale bars, 5 nm). Nanorods are rather uniform in diameter and have one sharpened end considered as the starting point of the rod growth (image **C**). Cross lattice fringes are resolved. The growth occurs along the InAs [111] plane. Measured distance between neighboring planes are 3.46 Angstrom, close to the *d* value for InAs [111] planes (3.5 Angstrom). Stacking faults are also resolved. For some rods the inventors detected a spherical particle in one end, with diameter larger than the mean nanorod diameter (image **D**). Although this particle is too small for chemical analysis, it is suggested that it is mainly composed of indium. This interpretation gains support from energy dispersive X-ray spectroscopy (EDS) analysis performed in the TEM on an area with many rods, yielding 56% In and 44% As (molar ratio). This result is consistent with EDS result for a full fraction of rods measured using microprobe analysis. This In/As ratio is higher than that in a typical sample of InAs nanodots (51% In over 49% As), indicating the existence of metallic indium, as also demonstrated in the XRD result.

The reduction process was studied by injecting an InCl₃/TOP solution at 340 °C, followed by rapid cooling to quench the reaction. Indium nanoparticles with a broad size distribution from a few nanometers to about 20 nm were obtained as shown in **Fig. 2D****.** The size of the droplets is much larger than the average diameter of the rods because even in the presence of a surfactant, the indium droplets grow rapidly at 340 °C, a temperature much higher than the melting point of indium metal.

In the method of the invention, both TOP and TOPO can be used as solvents, but TOPO has a higher boiling point than TOP (360 vs 300 °C), and thus enables a higher reaction temperature. Obviously, the higher reaction temperature leads to better crystallinity of the products. For the growth of rods there is a further advantage in the higher temperature condition as the yield of rod production is higher.

In order to optimize the synthesis conditions, the effect of the ratio between the precursors and the reducing agent was studied. This ratio, marked as P, was calculated as the molar ratio between arsenic and the upper limit of metallic indium calculated from the amount of reduction agent. The inventors studied syntheses with P ranging from 1 to 9. In TOP, since the reaction temperature is lower, annealing was needed for rod growth. In this condition, nanorods were obtained when P was as high as 9 although a large fraction of the rods were kinked and their yield was low. TOPO provided higher temperatures, under which rods formed immediately upon injection of precursors. The short reaction time means that growth of large indium nanodroplets can be mostly avoided, enabling the use of a lower ratio that results in a higher yield of rods. It was found that a ratio P of 4.5 is optimal in a typical synthesis conditions.

Other reducing agents may also be used instead of NaBH₄. Use of a reducing agent that is soluble in the stock solution, would provide better control over the size and uniformity of the nanodroplets. This can be achieved by injecting the reducing agent and the precursors together, and then a higher reaction temperature can be used with TOPO or other solvents with even higher boiling points.

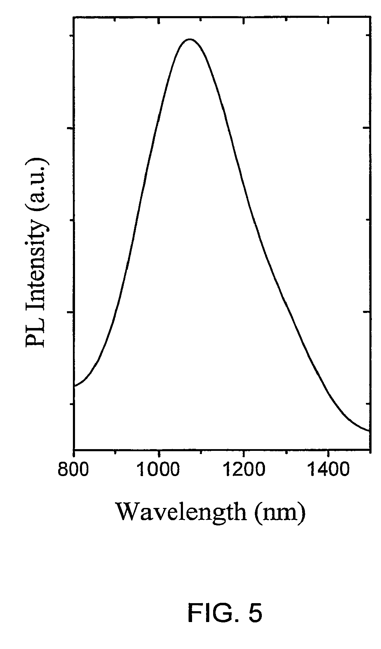

Concerning the optical properties of the InAs nanorods prepared by the method of the invention and by using In metal catalyst, the absorption spectrum exhibits a tail extending above 1 micron. **Fig. 5** illustrates the photoluminescence (PL) spectrum of the InAs nanorods shown in Fig. 2B. Rods-toluene solution was measured using a He-Ne laser for excitation (632 nm). The emission was collected as a right angle configuration, dispersed by a monochromator and detected by a InGaAs PIN photodetector with lock-in amplification. As can be seen in Fig. 5, the fluorescence maximum occurs at about 1080 nm.

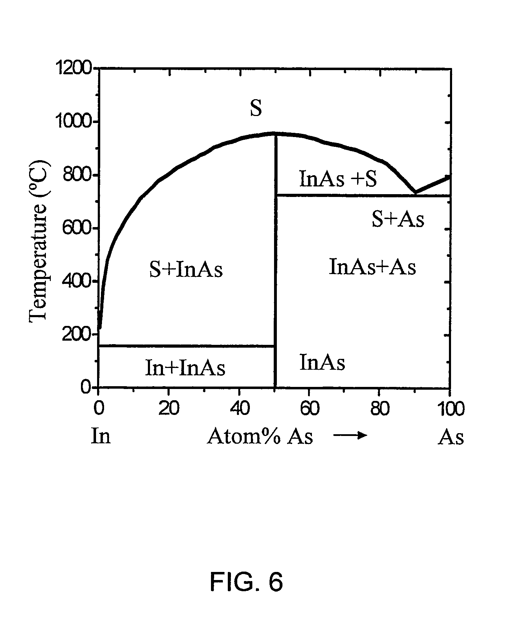

High temperature provide improved solubility of arsenic in indium, as indicated in the In-As binary phase diagram shown in **Fig. 6****,** as well as conditions to achieve better crystallinity and therefore improved quality of the rods. The indium-rich part shows three phases at different temperatures. At a high temperature, In-As alloy is in the melting state; at a medium temperature, rods and indium-arsenide alloy coexists; at a temperature below the melting point of indium, rod growth stops, the two solid phases, InAs and In are separated.

In another specific example, InAs nanorods were synthesized using Au nanoparticles to catalyze and direct one-dimensional growth of the nanorods. For InAs nanorods, the reaction between tris(trimethylsilyl)arsine ((TMS)₃As) and InCl₃ in trioctylphosphine-oxide (TOPO) was used. Dodecanethiol stabilized gold nanoparticles with diameter of about 2 nm were prepared using known methods [22]. These particles are readily soluble in the stock solution normally used for the synthesis of InAs nanorods. This allows for the injection of the gold nanoparticles together with the precursors, which was found to be critical for shape and size control of InAs nanorods.

In a typical experiment conducted under Argon flow, a stock solution containing 100 mg (0.34 mmol) (TMS)₃As, 1.57 g (0.68 mmol) InCl₃/trioctylphosphine (TOP) solution (0.3 g/ml), and 0.5 g gold/toluene solution (6.7 mg/g) in 1 g TOP was injected at 360 °C into the growth solution within 0.1 s under vigorous stirring, leading to the decrease of the reaction temperature to about 300 °C. A few seconds later, 2 g cold TOP was injected to further quench the temperature to about 220 °C and following, the reaction was cooled to room temperature. The process yields InAs nanorods with a uniform diameter and varying length distribution, along with byproducts including a small fraction of InAs quantum dots, InAs nanowires, and gold particles.

Optimization of the synthesis conditions was carried out in relation with the relative content of gold nanocrystals. The volume ratio between the stock and growth solution is an additional sensitive parameter in the method of the invention, as it determines the extent and rate of temperature quenching upon injection. A ratio of about 1:1 was found to be optimal. The temperature quenching can be further controlled by the time and volume of the secondary injection of solvent.

The rods were purified and size-selected by centrifugation according to the following procedure: the raw product was diluted with toluene and centrifuged at 6000 rpm (rcf-relative centrifugal force about 4000 g) for 20 min. In this first step, nanowires were precipitated together with other big particles while the nanorods and dots remained soluble. In the second step, nanorods were obtained. The particles were partially precipitated by adding methyl alcohol and then centrifuged. The resulting precipitate was redissolved with toluene and a fraction of nanorods with a mean length of about 22 nm and diameter of about 4 nm was obtained. This procedure was repeated providing a second and third fraction of InAs nanorods with mean lengths of about15 nm and about10 nm, respectively.

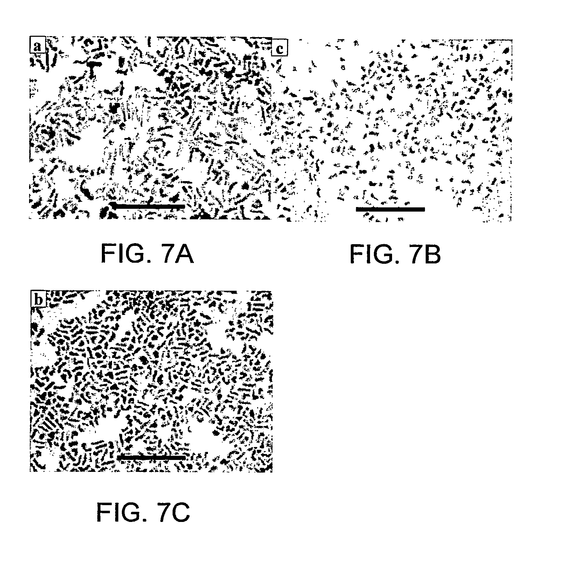

**Figs. 7A-C** present transmission electron microscopy (TEM) images of three fractions of nanorods, all with mean diameters of 4 nm, and varying lengths of 22 nm (Fig. 7A), 15 nm (Fig. 7B), and 10 nm (Fig. 7C). Gold particles, with increased contrast, could be identified at the end of many of the rods. The method clearly provides length controlled nanorods, and was also applied to InP demonstrating its generality.

The as-prepared InAs nanorods were crystalline as indicated in the XRD pattern

It should be pointed out that the reaction temperature in the method described above is surprisingly low (about 700 degrees below the melting point of bulk gold). This is possible because of the phenomena of decrease in the melting temperature of nanocrystals with reduced size. It was found by the inventors that syntheses at a lower reaction temperature of 300 °C, does not yield one-dimensional growth in this specific case indicating that the conditions are at the onset of melting. This is consistent with theoretical studies that have revealed that the melting temperature for AU₁₄₆ (diameter about 1.6 nm) was about 350 °C, increasing to about 480 °C in Au₄₅₉ clusters (diameter about 2.5 nm) and prior to melting, there is a region of temperatures where increased atomic diffusion near the surface takes place in the smaller clusters [**23**]. This may suffice for achieving the required function of the gold particles as catalysts. Notably, this temperature is below the boiling point of TOPO, a coordinating solvent for synthesis of high quality nanocrystals, allowing for the implementation of this method to achieve rod growth.

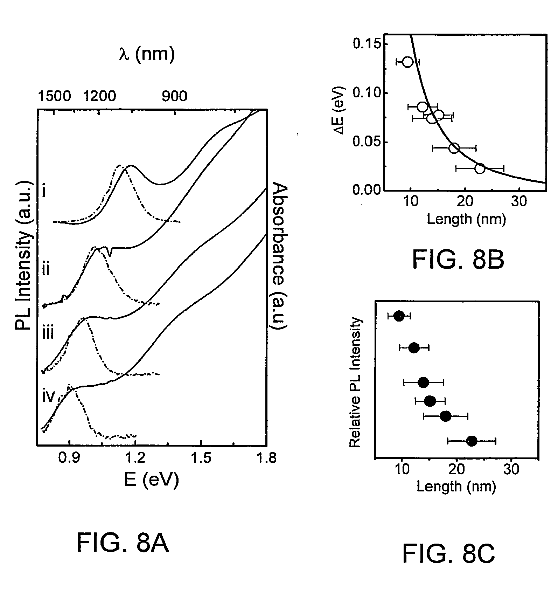

The importance of length and shape control for modifying the optical properties of the nanorods is demonstrated in **Fig 8A****,** presenting the room temperature absorption and photoluminescence of InAs rods of different lengths along with InAs dots with diameter similar to that of the rods. A gradual red-shift of the band gap appears for nanocrystals changing from dots to short rods and to longer rods, indicating strong quantum confinement in the length direction, to the extent that the photoluminescence of nanorods can effectively cover the telecommunications bands at 1.2-1.5 µm. The shift of the band gap with length is shown in **Fig. 8B****,** along with a simulation of this effect using a cylindrical particle-in-a-box model. **Fig. 8C** shows the dependence of the PL intensity on rod length showing decreased PL in longer rods. PL spectra were measured as described for figure 5 in page 17.

The observed band gap red shift with length in InAs rods is accompanied by a significant reduction in the photoluminescence (PL) intensity. This is also a signature of the gradual evolution of the confinement in the long rod axis.

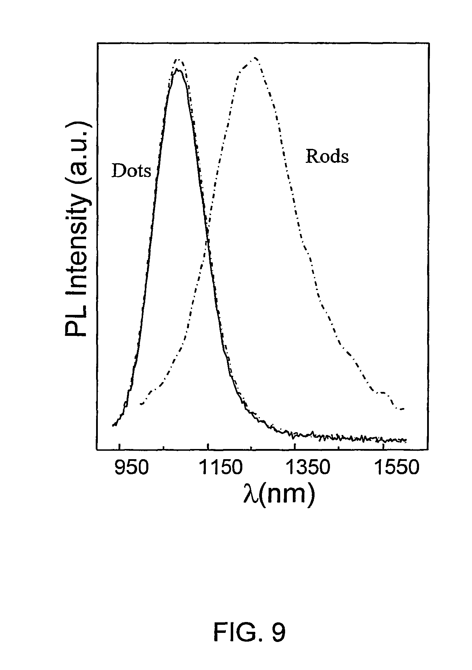

An additional distinct signature of the change in optical properties with the symmetry is demonstrated in **Fig. 9****,** showing polarized PL measurements on 17x4 nm InAs rods and 4 nm dots, both in a stretched polymer film. The dots exhibit unpolarized PL in correspondence with their spherical symmetry, while the rods show PL preferentially polarized along the stretching direction of the polymer, in accordance with their symmetry axis.

The use of small Au clusters (1.4 nm in mean diameter) instead of Au particles (2 nm in mean diameter) as mentioned above, was also carried out. In a typical experiment triphenylphosphine coated Au clusters with diameter of 1.4 nm and the suggested formula Au₁₀₁(PPh₃)₂₁Cl₅ (denoted as Au₁₀₁) were synthesized by the published procedures [**24**]. InAs rods were prepared as follows: a 4-neck flask was used, with 2 g TOPO as the growth solution. The stock solution contained 100 mg (0.34 mmol) (TMS)₃As, 0.57 g (0.68 mmol) InCl₃/TOP solution (0.3 g/ml), and 0.5 g gold/toluene solution (13.8 mg/g) in 1 g TOP. The growth solution was heated to 360 °C. The stock solution was then injected into the growth solution within 0.1 s under vigorous stirring, leading to the decrease of the reaction temperature to about 300 °C. A few seconds later, 2 g cold TOP was injected to further quench the temperature to about 220 °C and following, the reaction was cooled to room temperature. The rods were purified and size-selected by centrifugation. The raw product was diluted with toluene, removed to 5 ml vials, stopped with septum under nitrogen and centrifuged stepwise to obtain rods of different sizes.

In a similar way InAs quantum rods were synthesized by using Ag nanoparticles as catalyst. Dodecanethiol stabilized silver nanoparticles were synthesized by a method similar to that used for gold nanoparticles and size selective separation was employed to narrow the particle size distribution. 2 g TOPO was used as growth solvent and heated to 360 °C prior to precursor injection. 100 mg (TMS)₃As, 0.57 g InCl₃/TOP solution (0.3 g/ml), and 480 mg Ag/toluene solution (7.8 mg/g) were diluted with 1 g TOP and used as stock solution, which was injected within 0.1 s into the hot TOPO growth solution, and quenched within 3 seconds with 2 g cold TOP. A 2-step separation procedure was conducted to obtain InAs nanorods. First, the product was diluted with toluene and centrifuged at 6000 rpm for 20 min. InAs nanodots and nanorods were left in the supernatant. Second, nanorods were precipitated by adding methyl alcohol and then centrifuged at 6000 rpm for 10 min and re-dissolved in toluene.

In the above method, Ag nanoparticles of different sizes were used. With larger silver particles (diameter about 5 nm), only dots were obtained. When using smaller silver nanoparticles (about 3 nm in diameter), InAs nanorods were obtained.

Metal alloy and core-shell nanoparticles have also been used as catalysts in the method of the invention. In a typical preparation, Au/In catalyst nanoparticles of the desired size ranging from 2-20 nm in diameter were grown as reported previously [25]. Metal alloy nanoparticles are interesting catalysts for the growth of semiconductor rods due to their reduced melting temperature. In a typical preparation of InAs nanorods, a 4-neck flask was used, with 2 g TOPO as the growth solution. The stock solution contained 100 mg (0.34 mmol) (TMS)₃As, 0.57 g (0.68 mmol) InCl₃/TOP solution (0.3 g/ml), and 0.5 g gold-indium catalyst nanoparticles in toluene solution (13.8 mg/g) in 1 g TOP. The growth solution was heated to 360°C. The stock solution was then injected into the growth solution within 0.1 s under vigorous stirring, leading to the decrease of the reaction temperature to about 300 °C. Less then 3 seconds later, 2 g cold TOP was injected to further quench the temperature to about 220 °C and following, the reaction was cooled to room temperature. The rods were purified and size-selected by centrifugation. The raw product was diluted with toluene, removed to 5 ml vials, stopped with septum under nitrogen and centrifuged stepwise to obtain rods of different sizes.

The method of the present invention may be easily extended to the preparation of nanorods of various inorganic semiconductors. Group IIIa-Va semiconductors, e.g. InP or GaAs, can be prepared using tris(trimethylsilyl)arsine/phosphine and InCl₃ or GaCl₃ as precursors. Thus, for example, InP nanorods were prepared by the following procedure: 2 g TOPO were placed in a 4-neck flask as the growth solution and heated to 360 °C and stirred vigorously. A stock solution containing 85 mg (about 0.34 mmol) tris(trimethylsilyl)phosphine, 0.57 g (0.68 mmol) InCl₃/TOP solution (0.3 g/ml), and 0.5 g gold nanocrystal/toluene solution (6.7 mg/g) was diluted with 1 g TOP. Au nanocrystals with a diameter of 2 nm were used. The stock solution was injected into the growth solution and a few seconds later, 2 g cold TOP was injected to further quench the reaction. Subsequently, the reaction was cooled to room temperature. The 2-step separation procedure described above was also used here to obtain InP nanorods.

In another example, GaAs nanorods were prepared according to the following synthesis: a concentrated stock solution of GaCl₃ was prepared by dissolving 2 g GaCl₃ (Aldrich, 99.999%) in 10 ml TOP in the glovebox. 1.233 g GaCl₃/TOP solution, 100 mg (TMS)₃As, and 0.57 g Au nanoparticle-toluene solution were diluted with 0.5 g TOP. This stock solution was injected to TOPO at a temperature ranging from 300-380°C. Shape controlled GaAs nanocrystals were also obtained by the 2-step separation procedure.

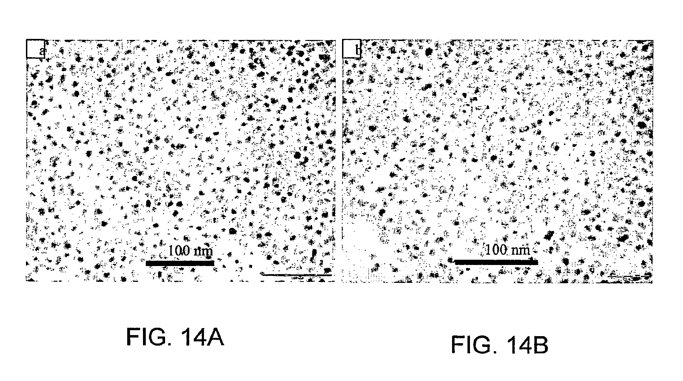

TEM images of (A) InP and (B)GaAs nanorods are shown in **Fig. 14****.**

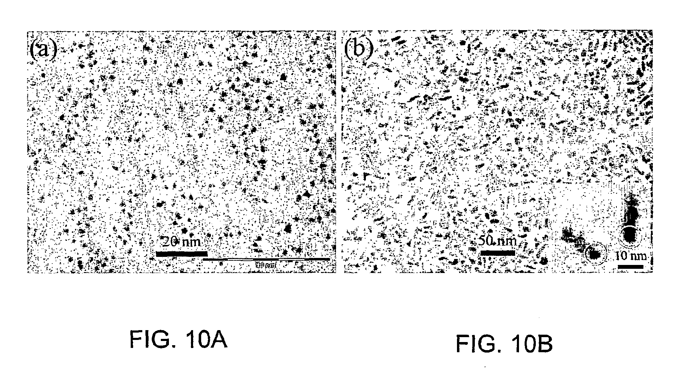

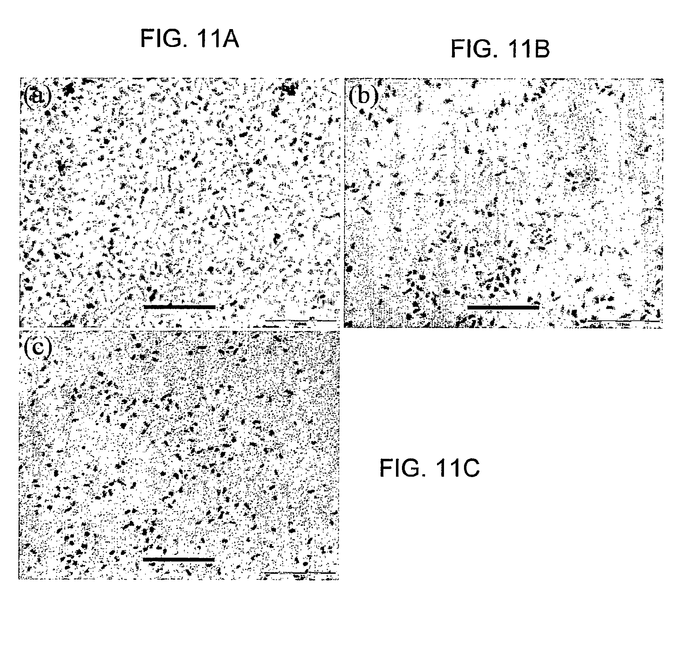

A demonstration of the results obtained by using Au₁₀₁ clusters as the catalyst particles, are shown in **Figs. 10.** Fig. 10A presents a TEM image of the Au₁₀₁ clusters without further size selection, while Fig.10B presents a TEM image of the InAs nanorods clearly revealing the one-dimensional growth mode. The inset of Fig. 10B shows rods with gold particles on the end, demonstrating the SLS growth mechanism. The synthesis in this case yields InAs nanorods with a uniform diameter but broad length distribution, along with a certain amount of byproducts including a small fraction of InAs quantum dots, InAs nanowires, and gold particles. Centrifugation was used to separate these products. In the first step of separation, the product dispersed in toluene was centrifuged at 6000 rpm (rcf-relative centrifugal force about 4000 g) for 20 min. In this step, nanorods and dots remained in the supernatant. In the second step, nanorods were obtained. The particles were partially precipitated by adding methyl alcohol and then centrifuged at 6000 rpm (rcf about 4000 g) for 10 min. The resulting precipitate was redissolved with toluene and a fraction of nanorods with a mean length of 14.2 nm was obtained. This procedure was repeated providing a second and third fraction of InAs nanorods with mean lengths of 10.1 nm and 7.4 nm, respectively. **FigS. 11A-C** present TEM images of these three fractions of nanorods, all with mean diameters of 3.7 nm. Following this, a diluted solution containing mostly InAs dots was left.

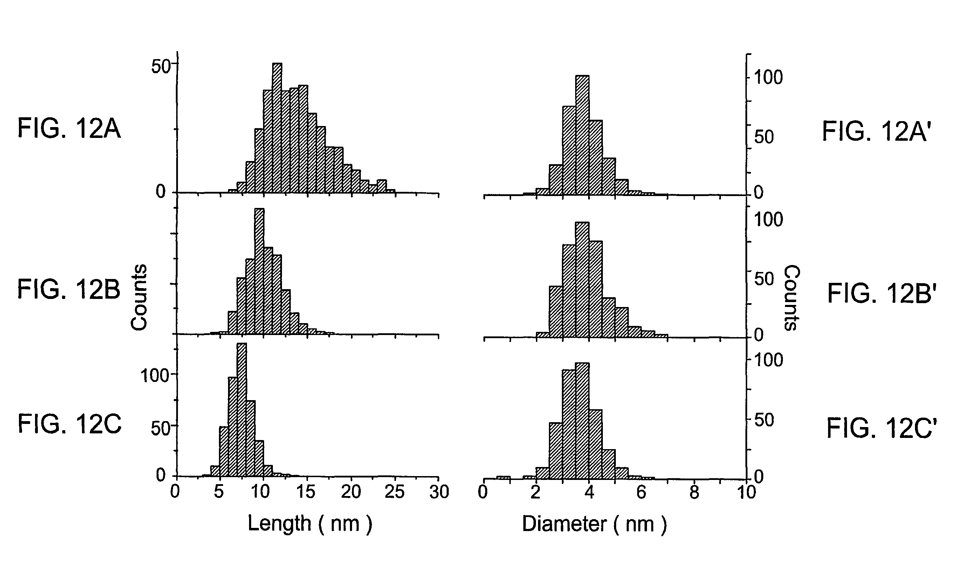

**Fig. 12** show histograms representing the diameter and length distributions in the three nanorod fractions discussed above, clearly revealing the similar diameters and varying lengths. The width of the diameter distribution is 20-25%, while the length distribution is 15-20%. First fraction, with mean length 14.2±4.0 nm (histogram **A**), diameter 3.8±0.7 nm (histogram **A'**). Second fraction, with length 10.1±2.1 nm (histogram **B**), diameter 3.9±0.8 nm (histogram **B'**). Third fraction, with length 7.4±1.4 nm (histogram C), diameter 3.6±0.7 nm (histogram (**C'**).

The relative molar ratio of gold to (TMS)₃As in the precursor solution was varied between 2.5 to 20%. At low gold cluster content, the chemical yield of rods is low. At high gold cluster content, precipitation took place immediately following the injection. This is most likely caused by aggregation of the gold clusters providing large seeds for rapid InAs growth. An optimal ratio of 10% gold yielded InAs nanorods with uniform diameters at high yield. This is higher than the optimal value of 5% obtained when using gold nanoparticles. This behavior may be explained by less efficient catalysis reaction using smaller gold particles, due to increased aggregation.

The annealing time is critical for the synthesis. With a very short annealing time (interval between the two injections much shorter than 1s), very low yield of rods was obtained, and on the other hand, when the annealing time is longer than 3 s, most of the particles precipitate. The best results are obtained for injecting the quenching solution 1-2 s after the first injection.

The volume ratio between the stock and growth solution (Vₛ/V_{g}) is an additional very sensitive parameter in the method of the invention as it determines the extent and rate of temperature quenching upon injection. A range of ratios from 1:1 to 1:3 was examined. With a low ratio (Vₛ/V_{g} = 1:3), a large fraction of the reaction products are precipitated and at the same time, most of the particles in the solution are rods with similar length and diameter. A 1:1 volume ratio was found to be optimal, yielding the results discussed above. Diluting the concentration of the reactants can provide kinetic control of the growth, which is under investigation.

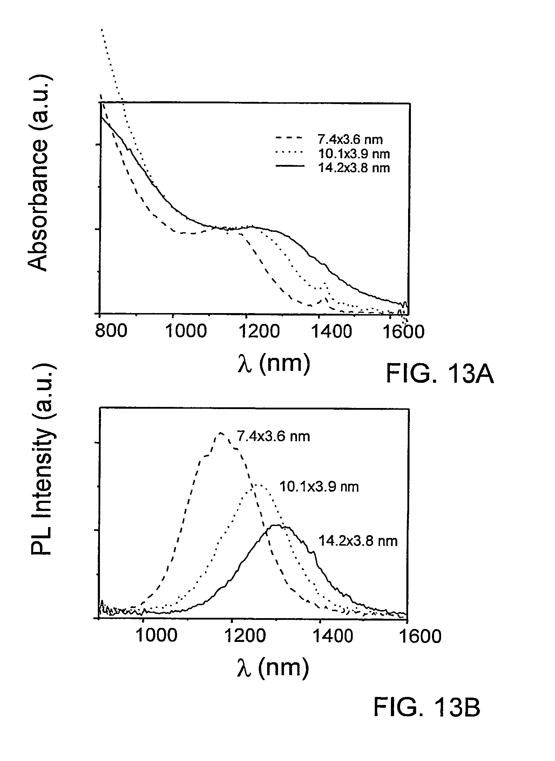

Length dependent optical properties of the InAs nanorods synthesized using Au₁₀₁ clusters are presented in **Fig. 13** showing room temperature absorption (**Fig. 13A**), and photoluminescence (PL) (**Fig. 13B**) for the three rod fractions shown in Fig. 11. Solid lines, rods with length 14.2±4.0 nm, diameter 3.8±0.7 nm, dotted lines, rods with length 10.1±2.1 nm, diameter 3.9±0.8 nm, dashed lines, rods with length 7.4±1.4 nm, diameter 3.6±0.7 nm. Clearly, the band gap decreases with the increase of rod length and the PL of the 14.2x3.9 nm fraction peaks at 1.3 µm, overlapping the short wavelength telecomm band. Additionally, the relative PL intensity of the rods was also reduced upon increased rod length. Similar behavior was observed at low temperature, T = 10 K, for InAs rods with dimensions of 3.7x7.4 nm, 3.7x14.2 nm and 4x20 nm. The nanocrystals obtained by the method of the invention usually have organic ligands as a coating on their outer surfaces. Such organic ligands affect the solubility of the particles and may be substituted or removed, according to the application intended for said particles. For example, when the reaction is carried out in TOPO, TOP or mixtures thereof, the nanocrystals are coated with tri-octylphosphine groups that allows them to dissolve in non-polar solvents such as toluene, hexane etc. The capping groups may be replaced by polar groups such as mercaptoacetic acid or substituted by other thio-carboxylic acids or amides, thus affording the solubility of the particles in polar solvents and even in water.

The method of the present invention may be easily extended to the preparation of nanorods of various inorganic semiconductors. Alloy rods can also be made in a similar fashion by proper mixing of the precursors although the alloy composition will then also be determined by the different solubility of the different precursors in the catalytic metal particle.

Rod/shell nanocrystals based on InAs nanorods, e.g. InAs/ZnSe or InAs/CdSe, may be prepared to improve the photoluminescence quantum yield and to provide further control of the optical and electronic properties of the nanorods [**19, 20**].

The nanorods of the present invention can serve as an optical medium, which when exposed to laser radiation, produces stimulated gain emission. By changing the diameter of the rod, which can easily be controlled in the technique of the present invention (i.e., by defining a desired diameter of the metallic catalyst), the absorption and emission spectrum of the medium can be appropriately adjusted: the larger the diameter of the rod, the longer the absorption and emission wavelength. These properties of the nanorods of the present invention enable their use in optical amplifiers, as lasing materials, in NIR light detectors, and in photocells.

The rod/shell nanocrystals of the present invention can be used as an optical amplifier having a stable bandwidth, in wideband optical amplifiers and lasers having adjustable center-frequency and bandwidth. In order to realize a wideband optical amplifier for amplifying data-carrying optical signals propagating in a light transmitting medium (e.g., a segment of optical fiber), a pumping, coherent-light source connected to the light transmitting medium (e.g., a segment of optical fiber) is used for exciting a plurality of semiconductor core/shell nanorods with light energy required for the amplification of the data-carrying optical signals within a specific optical band. To this end, each nanorod has core dimensions that correspond to this specific optical band and is located at a predetermined point within the light transmitting medium.

In modem data communication systems, amplification of data-carrying optical signals is typically required to compensate for losses in the magnitude of the optical signals caused by the signal propagation through an optical fiber. In the optical data communication system, a wideband optical amplifier formed by the nanorods of the present invention (or a sequence of such amplifiers) is interconnected, by segments of light transmitting medium, between a modulator connected to a data-source for modulating an optical signal with data to be carried from the data-source to a destination by the optical signal, and a demodulator located at the destination for demodulating the data-carrying optical signals.

For a variety of telecommunication purposes, there is a need for materials having emittance and optical gain as well as laser action, tunable in the Near IR (NIR) spectral range. The tunability of the band gap luminescence of the InAs nanorods over the range can be achieved by varying its diameter. By applying a shell of another semiconductor, the luminescence wavelengths of nanocrystals can be modified. A laser can be achieved by uniformly dispersing a plurality of nanorods of the present invention in a laser host medium, thereby obtaining an active lasing medium, and using a pumping source for exciting each of said nanorods, and an optical cavity that provides an optical feedback mechanism for the coherent light produced by the laser active medium.

Due to the rod-like geometry of the nanocrystals of the present invention, substantially homogeneous orientation of the long axes of the nanorods can be obtained (e.g., by stretching the nanocrystal film). This property allows for using the nanorods of the present invention as an active polarizing medium in an optical device such as light emitting diode, laser, and display, to obtain a specific polarization direction of the output light.

Due to the controllable length and diameter of the rods of the present invention, they are also useful as important elements in composite photocells. One example is by forming a device where InP nanorods are embedded in a semiconducting polymer spin cast on a conductive and transparent substrate such as ITO glass that will serve as one electrode and on top of the polymer a second electrode is prepared by evaporating a suitable metal. Under solar light illumination, light energy can be absorbed by the InP rods and also by the polymer, and in a second step, charge separation will take place where electrons remain on the nanorods and hole will be transferred to the polymer. Then, the electrons flow to the positive bias side of the device, while holes flow through the polymer to the negative bias side thereby resulting in transformation of solar energy to electrical energy that can be later used or stored in various known forms. Controlling the length and the diameter of the nanorods allows for appropriately varying of, respectively, a distance of the electrons direct flow through the device and the absorption/emission spectrum of the device.

Those skilled in the art will readily appreciate that various modifications and changes can be applied to the present invention as hereinbefore described without departing from its scope defined in and by the appended claims.

## Claims

1. A method for the production of inorganic semiconductor nanocrystals having a rod-like shape, the method comprising:
(i) reacting, in a high-boiling point organic solvent and at an elevated temperature, either a two-source precursor solution comprising at least one metal source and at least one nonmetal source, or a single-source precursor solution, with nanoparticles of a metal catalyst or an agent capable of producing said nanoparticles of the metal catalyst, thereby forming a reaction product comprising semiconductor nanocrystals of various shape; and
(ii) purifying said reaction product so as to obtain semiconductor nanocrystals having substantially rod-like shape.

2. The method of Claim 1, wherein said elevated temperature is above 200°C.

3. The method of Claim 1, wherein said elevated temperature is above 300°C.

4. The method of Claim 1, 2 or 3 wherein said reaction product obtained in step (i) is cooled before its purification in step (ii).

5. The method according to any of claims 1-4 wherein said purification in step (ii) is carried out by centrifugation, thereby affording size-selected inorganic semiconductor nanocrystals having a rod-like shape.

6. The method according to anyone of Claims 1 to 5, wherein said metal source is a Group IIIa metal compound.

7. The method according to anyone of Claims 1 to 5, wherein said metal source is a Group IIb metal compound.

8. The method according to anyone of Claims 1 to 5, wherein said metal source is a Group Ib metal compound.

9. The method according to claim 6, wherein said Group IIIa metal compound is a Group IIIa metal salt.

10. The method according to Claim 9, wherein said Group IIIa metal salt is a Group IIIa metal halide.

11. The method according to Claim 10, wherein said Group IIIa metal halide is InCl₃.

12. The method according to anyone of Claims 1 to 5, wherein said nonmetal source is a Group Va compound.

13. The method according to Claim 12, wherein said Group Va nonmetal source is in elemental form.

14. The method according to claim 12, wherein said Group Va compound is a tris(trialkylsilyl) derivative of a Group Va element.

15. The method according to claim 14, wherein said Group Va compound is tris(trialkylsilyl)arsenine.

16. The method according to anyone of Claims 1 to 5, wherein said nonmetal source is a Group VIa compound.

17. The method according to anyone of Claims 1 to 5, wherein said nonmetal source is a Group VIIa compound.

18. The method according to anyone of Claims 1 to 5, wherein said nonmetal source is a Group VIa element.

19. The method according to anyone of Claims 1 to 5, wherein said single-source precursor is selected from the group consisting of a compound comprising both Group Ib and Group VIIa elements, a compound comprising both Group IIb and Group VIa elements, a compound comprising both Group IIIa and Group Va elements, and a compound comprising a Group IVa clement.

20. The method according to anyone of Claims 1 to 19, wherein said agent capable of producing said metal catalyst is a reducing agent.

21. The method according to Claim 20, wherein said reducing agent is selected from NaBH₄, KBH₄, and Na₂SO₃.

22. The method according to anyone of Claims 1 to 19, wherein said metal catalyst is selected from a transition metal, a Group IIIa metal and alloys or core/shell layered structures of such metals.

23. The method according to Claim 22, wherein said metal catalyst is selected from a Group Ib metal, a Group IIb metal, a Group VIII metal and alloys of such metals.

24. The method according to Claim 22, wherein said metal catalyst is gold.

25. The method according to Claim 24, wherein the gold catalyst is in the form of nanoparticles.

26. The method according to Claim 25, wherein said nanoparticles are in the form of nanocrystals, clusters or mixtures thereof.

27. The method according to Claim 22, wherein said Group IIIa metal is selected from Al, Ga, In or alloys and layered particles thereof.

28. The method according to Claim 22, wherein said metal catalyst is selected from Fe, Zn, Pd, Pt, Ni, Co, Mn, Ag, Cd or alloys and layered particles thereof.

29. The method according to Claim 22, wherein said metal catalyst comprises an Au-In alloy or Au/In core/shell layered compound.

30. The method according to anyone of Claims 1 to 29, wherein said high boiling point solvent is a strongly coordinating organic solvent.

31. The method according to Claim 30, wherein said solvent is selected from trioctylphosphine (TOP), trioctylphosphine oxide (TOPO), triphenylphosphine (TPP), triphenylphosphine-oxide (TPPO), hexadecyl amine (HDA) and dodecylamine (DDA).

32. The method according to anyone of Claims 1 to 31, wherein step (i) is carried out under a pressure higher than normal pressure.

## Patentansprüche

1. Verfahren zur Herstellung anorganischer Halbleiter-Nanokristalle mit einer stabartigen Form, wobei das Verfahren umfasst:
(i) Auslösen von Reaktion entweder einer Vorläuferlösung aus zwei Quellen, die wenigstens eine Metall-Quelle und wenigstens eine Nichtmetall-Quelle umfasst, oder einer Vorläuferlösung aus einer Quelle mit Nanopartikeln eines Metallkatalysators oder eines Wirkstoffs, der in der Lage ist, die Nanoteilchen des Metallkatalysators zu erzeugen, in einem hochsiedenden Lösungsmittel bei erhöhter Temperatur, um so ein Reaktionsprodukt auszubilden, das Halbleiter-Nanokristalle verschiedener Form umfasst; und
(ii) Reinigen des Reaktionsproduktes, um Halbleiter-Nanokristalle zu gewinnen, die im Wesentlichen stabartige Form haben.

2. Verfahren nach Anspruch 1, wobei die erhöhte Temperatur über 200 °C beträgt.

3. Verfahren nach Anspruch 1, wobei die erhöhte Temperatur über 300 °C beträgt.

4. Verfahren nach Anspruch 1, 2 oder 3, wobei das Reaktionsprodukt, das in Schritt (i) gewonnen wird, vor seiner Reinigung in Schritt (ii) abgekühlt wird.

5. Verfahren nach einem der Ansprüche 1-4, wobei die Reinigung in Schritt (ii) durch Zentrifugieren ausgeführt wird, so dass nach Größe selektierte anorganische Halbleiter-Nanokristalle mit einer stabartigen Form entstehen.

6. Verfahren nach einem der Ansprüche 1 bis 5, wobei die Metall-Quelle eine Metallverbindung der Gruppe IIIa ist.

7. Verfahren nach einem der Ansprüche 1 bis 5, wobei die Metall-Quelle eine Metallverbindung der Gruppe IIb ist.

8. Verfahren nach einem der Ansprüche 1 bis 5, wobei die Metall-Quelle eine Metallverbindung der Gruppe Ib ist.

9. Verfahren nach Anspruch 6, wobei die Metallverbindung der Gruppe IIIa ein Metallsalz der Gruppe IIIa ist.

10. Verfahren nach Anspruch 9, wobei das Metallsalz der Gruppe IIIa ein Metallhalogenid der Gruppe IIIa ist.

11. Verfahren nach Anspruch 10, wobei das Metallhalogenid der Gruppe IIIa InCl₃ ist.

12. Verfahren nach einem der Ansprüche 1 bis 5, wobei die Nichtmetall-Quelle eine Verbindung der Gruppe Va ist.

13. Verfahren nach Anspruch 12, wobei die Nichtmetall-Quelle der Gruppe Va in elementarer Form vorliegt.

14. Verfahren nach Anspruch 12, wobei die Verbindung der Gruppe Va ein Tris(trialkylsilyl)-Derivat eines Elementes der Gruppe Va ist.

15. Verfahren nach Anspruch 14, wobei die Verbindung der Gruppe Va Tris(trialkylsilyl)-Arsenin ist.

16. Verfahren nach einem der Ansprüche 1 bis 5, wobei die Nichtmetall-Quelle eine Verbindung der Gruppe VIa ist.

17. Verfahren nach einem der Ansprüche 1 bis 5, wobei die Nichtmetall-Quelle eine Verbindung der Gruppe VIIa ist.

18. Verfahren nach einem der Ansprüche 1 bis 5, wobei die Nichtmetall-Quelle ein Element der Gruppe VIa ist.

19. Verfahren nach einem der Ansprüche 1 bis 5, wobei der Vorläufer aus einer Quelle aus der Gruppe ausgewählt wird, die aus einer Verbindung, die sowohl Elemente der Gruppe Ib als auch der Gruppe VIIa umfasst, einer Verbindung, die sowohl Elemente der Gruppe IIb als auch der Gruppe VIa umfasst, einer Verbindung, die sowohl Elemente der Gruppe IIIa als auch der Gruppe Va umfasst, und einer Verbindung besteht, die ein Element der Gruppe IVa umfasst.

20. Verfahren nach einem der Ansprüche 1 bis 19, wobei der Wirkstoff, der in der Lage ist, den Metallkatalysator zu erzeugen, ein reduzierender Wirkstoff ist.

21. Verfahren nach Anspruch 20, wobei der reduzierende Wirkstoff aus NaBH₄, KBH₄ und Na₂SO₃ ausgewählt wird.

22. Verfahren nach einem der Ansprüche 1 bis 19, wobei der Metallkatalysator aus einem Übergangsmetall, einem Metall der Gruppe IIIa und Legierungen oder aus Kern und Schale geschichteten Strukturen derartiger Metalle ausgewählt wird.

23. Verfahren nach Anspruch 22, wobei der Metallkatalysator aus einem Metall der Gruppe Ib, einem Metall der Gruppe IIb, einem Metall der Gruppe VIII und Legierungen derartiger Metalle ausgewählt wird.

24. Verfahren nach Anspruch 22, wobei der Metallkatalysator Gold ist.

25. Verfahren nach Anspruch 24, wobei der Goldkatalysator in Form von Nanoteilchen vorliegt.

26. Verfahren nach Anspruch 25, wobei die Nanoteilchen in Form von Nanokristallen, Clustern oder Gemischen daraus vorliegen.

27. Verfahren nach Anspruch 22, wobei das Metall der Gruppe IIIa aus Al, Ga, In oder Legierungen und geschichteten Teilchen derselben ausgewählt wird.

28. Verfahren nach Anspruch 22, wobei der Metallkatalysator aus Fe, Zn, Pd, Pt, Ni, Co, Mn, Ag, Cd oder Legierungen und geschichteten Teilchen derselben ausgewählt wird.

29. Verfahren nach Anspruch 22, wobei der Metallkatalysator eine Au-In-Legierung oder eine aus Kern und Schale geschichtete Verbindung aus Au/In umfasst.

30. Verfahren nach einem der Ansprüche 1 bis 29, wobei das hochsiedende Lösungsmittel ein stark koordinativ wirkendes organisches Lösungsmittel ist.

31. Verfahren nach Anspruch 30, wobei das Lösungsmittel aus Trioctylphosphin (TOP), Trioctylphosphinoxid (TOPO), Triphenylphosphin (TPP), Triphenylphosphinoxid (TPPO), Hexadecylamin (HDA) und Dodecylamin (DDA) ausgewählt wird.

32. Verfahren nach einem der Ansprüche 1 bis 31, wobei Schritt (i) unter einem Druck ausgeführt wird, der höher ist als Normaldruck.

## Revendications

1. Procédé de fabrication de nanocristaux inorganiques semi-conducteurs ayant une forme de tige, le procédé comprenant :
(i) la réaction, dans un solvant organique à haut point d'ébullition et à une température élevée, soit d'une solution de précurseur à deux sources comprenant au moins une source de métal et au moins une source de non-métal, soit d'une solution de précurseur à source unique, avec des nanoparticules d'un catalyseur métallique ou d'un agent apte à produire lesdites nanoparticules du catalyseur métallique, formant ainsi un produit de réaction comprenant des nanocristaux semi-conducteurs de forme variée ; et
(ii) la purification dudit produit de réaction de façon à obtenir des nanocristaux semi-conducteurs ayant essentiellement une forme de tige.

2. Procédé selon la revendication 1, dans lequel ladite température élevée est supérieure à 200°C.

3. Procédé selon la revendication 1, dans lequel ladite température élevée est supérieure à 300°C.

4. Procédé selon la revendication 1, 2 ou 3, dans lequel ledit produit de réaction obtenu dans l'étape (i) est refroidi avant sa purification dans l'étape (ii).

5. Procédé selon l'une quelconque des revendications 1 à 4, dans lequel ladite purification dans l'étape (ii) est effectuée par centrifugation, donnant ainsi des nanocristaux inorganiques semi-conducteurs de taille choisie, ayant une forme de tige.

6. Procédé selon l'une quelconque des revendications 1 à 5, dans lequel ladite source de métal est un composé de métal du groupe IIIa.

7. Procédé selon l'une quelconque des revendications 1 à 5, dans lequel ladite source de métal est un composé de métal du groupe IIb.

8. Procédé selon l'une quelconque des revendications 1 à 5, dans lequel ladite source de métal est un composé de métal du groupe Ib.

9. Procédé selon la revendication 6, dans lequel ledit composé de métal du groupe IIIa est un sel de métal du groupe IIIa.

10. Procédé selon la revendication 9, dans lequel ledit sel de métal du groupe IIIa est un halogénure de métal du groupe IIIa.

11. Procédé selon la revendication 10, dans lequel ledit halogénure de métal du groupe IIIa est InCl₃.

12. Procédé selon l'une quelconque des revendications 1 à 5, dans lequel ladite source de non-métal est un composé du groupe Va.

13. Procédé selon la revendication 12, dans lequel ladite source de non-métal du groupe Va est sous forme élémentaire.

14. Procédé selon la revendication 12, dans lequel ledit composé du groupe Va est un dérivé tris(trialkyl-silylé) d'un élément du groupe Va.

15. Procédé selon la revendication 14, dans lequel ledit composé du groupe Va est une tris(trialkylsilyl)-arsénine.

16. Procédé selon l'une quelconque des revendications 1 à 5, dans lequel ladite source de non-métal est un composé du groupe VIa.

17. Procédé selon l'une quelconque des revendications 1 à 5, dans lequel ladite source de non-métal est un composé du groupe VIIa.

18. Procédé selon l'une quelconque des revendications 1 à 5, dans lequel ladite source de non-métal est un élément du groupe VIa.

19. Procédé selon l'une quelconque des revendications 1 à 5, dans lequel ledit précurseur à source unique est choisi dans le groupe constitué par un composé comprenant des éléments à la fois du groupe Ib et du groupe VIIa, un composé comprenant des éléments à la fois du groupe IIb et du groupe VIa, un composé comprenant des éléments à la fois du groupe IIIa et du groupe Va, et un composé comprenant un élément du groupe IVa.

20. Procédé selon l'une quelconque des revendications 1 à 19, dans lequel ledit agent apte à produire ledit catalyseur métallique est un agent réducteur.

21. Procédé selon la revendication 20, dans lequel ledit agent réducteur est choisi parmi NaBH₄, KBH₄ et Na₂SO₃.

22. Procédé selon l'une quelconque des revendications 1 à 19, dans lequel ledit catalyseur métallique est choisi parmi un métal de transition, un métal du groupe IIIa et les alliages ou les structures stratifiées coeur/enveloppe de tels métaux.

23. Procédé selon la revendication 22, dans lequel ledit catalyseur métallique est choisi parmi un métal du groupe Ib, un métal du groupe IIb, un métal du groupe VIII et les alliages de tels métaux.

24. Procédé selon la revendication 22, dans lequel ledit catalyseur métallique est l'or.

25. Procédé selon la revendication 24, dans lequel le catalyseur or est sous la forme de nanoparticules.

26. Procédé selon la revendication 25, dans lequel ledites nanoparticules sont sous la forme de nanocristaux, d'amas ou de mélanges de ceux-ci.

27. Procédé selon la revendication 22, dans lequel ledit métal du groupe IIIa est choisi parmi Al, Ga, In ou les alliages et les particules stratifiées de ceux-ci.

28. Procédé selon la revendication 22, dans lequel ledit catalyseur métallique est choisi parmi Fe, Zn, Pd, Pt, Ni, Co, Mn, Ag, Cd ou les alliages et les particules stratifiées de ceux-ci.

29. Procédé selon la revendication 22, dans lequel ledit catalyseur métallique comprend un alliage Au-In ou un composé stratifié coeur/enveloppe Au/In.

30. Procédé selon l'une quelconque des revendications 1 à 29, dans lequel ledit solvant à haut point d'ébullition est un solvant organique à fort degré de coordination.

31. Procédé selon la revendication 30, dans lequel ledit solvant est choisi parmi la trioctylphosphine (TOP), l'oxyde de trioctylphosphine (TOPO), la triphénylphosphine (TPP), l'oxyde de triphénylphosphine (TPPO), l'hexadécylamine (HDA) et la dodécylamine (DDA).

32. Procédé selon l'une quelconque des revendications 1 à 31, dans lequel l'étape (i) est effectuée sous une pression supérieure à la pression normale.
